# EUROPÄISCHE PATENTSCHRIFT

(11) **EP 2 238 631 B1**
(45) Veröffentlichungstag und Bekanntmachung des Hinweises auf die Patenterteilung: **20.06.2012**
(21) Anmeldenummer: 08871588.3
(22) Anmeldetag: 10.12.2008
(51) Int. Cl.: H01L 35/08, H01L 35/34

(54) **VERFAHREN ZUR HERSTELLUNG EINES THERMOELEKTRISCHEN BAUELEMENTES UND THERMOELEKTRISCHES BAUELEMENT**
METHOD FOR THE PRODUCTION OF A THERMOELECTRIC COMPONENT AND THERMOELECTRIC COMPONENT
PROCÉDÉ DE FABRICATION D'UN COMPOSANT THERMOÉLECTRIQUE ET COMPOSANT THERMOELECTRIQUE

(30) Priorität: 23.01.2008 DE 102008005694
(43) Veröffentlichungstag der Anmeldung: 13.10.2010
(73) Patentinhaber: Fraunhofer-Gesellschaft zur Förderung der angewandten Forschung e.V., 80686 München (DE)
(72) Erfinder: KÖNIG, Jan, 79112 Freiburg (DE); VETTER, Uwe, 79410 Badenweiler (DE); MATHEIS, Carsten, 66583 Spiesen-Elversberg (DE)
(74) Vertreter: Grünecker, Kinkeldey, Stockmair & Schwanhäusser
(86) Internationale Anmeldenummer: PCT/EP2008/010480
(87) Internationale Veröffentlichungsnummer: WO 2009/092421

(56) Entgegenhaltungen:
- WO-A2-2007/002337
- US-A- 4 855 810
- US-A- 5 429 680
- US-A1- 2004 042 181

## Beschreibung

Die vorliegende Erfindung betrifft ein Verfahren zur Herstellung eines thermoelektrischen Bauelementes gemäß dem Oberbegriff des Patentanspruchs 1. Des weiteren betrifft die vorliegende Erfindung ein thermoelektrisches Bauelement.

Die Funktionsweise eines thermoelektrischen Bauelementes beruht auf dem thermoelektrischen Effekt, der auch Seebeck-Effekt bzw. Peltier-Effekt genannt wird. Das Anwendungsgebiet der vorliegenden Erfindung ist somit die Thermoelektrik. Ein thermoelektrisches Bauelement kann zum einen zur Energieerzeugung als thermoelektrischer Generator eingesetzt werden, und zum anderen zur Temperaturregulierung als Peltier-Element. Ein drittes Anwendungsgebiet für thermoelektrische Bauelemente sind Sensoren, z.B. Thermoelemente und Thermosäulen.

Bei einem thermoelektrischen Generator wird durch einen Temperaturunterschied eine Spannung und somit ein elektrischer Strom erzeugt. Umgekehrt wird bei einem Peltier-Element durch Anlegen einer Spannung und durch den resultierenden Stromfluss eine Seite des thermoelektrischen Bauelementes erwärmt und die andere Seite des thermoelektrischen Bauelementes gekühlt. Wird das thermoelektrische Bauelement als Temperatursensor eingesetzt, wird eine Temperaturänderung über eine Spannungsänderung am Ausgang des thermoelektrischen Bauelementes detektiert.

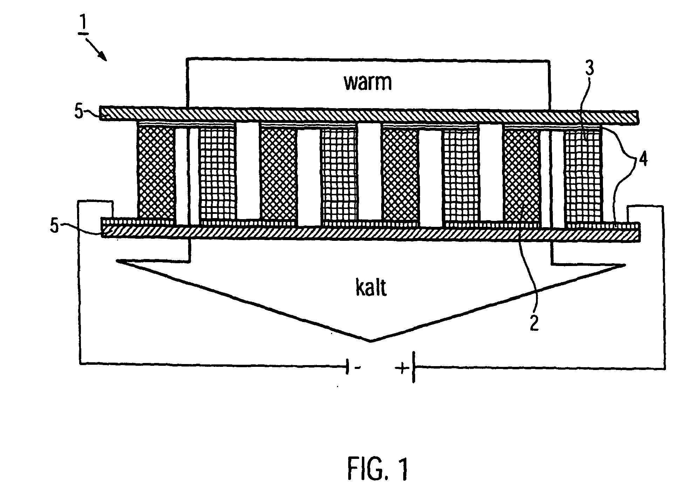

In Fig. 1 ist der grundsätzliche Aufbau eines thermoelektrischen Bauelementes 1 gezeigt. Prinzipiell setzt sich ein derartiges thermoelektrisches Bauelement 1 aus thermoelektrischen Schenkelpaaren mit n-Schenkeln 2 und p-Schenkeln 3 zusammen. Bei diesen n- und p-Schenkeln 2, 3 handelt es sich um n- und p-leitende Materialien, wie sie auch in anderen Bereichen der Halbleitertechnik verwendet werden. Durch ein elektrisch leitfähiges Kontaktmaterial 4 werden die n-Schenkel 2 und die p-Schenkel 3 wechselseitig miteinander kontaktiert. Somit sind die n- und p-Schenkel 2, 3 elektrisch in Reihe geschaltet und thermisch parallel geschaltet. Die thermoelektrischen Schenkelpaare sowie das elektrisch leitfähige Kontaktmaterial 4 sind zwischen Schichten eines elektrisch isolierenden Substrats 5 vorgesehen.

Wie in Fig. 1 schematisch dargestellt, herrscht zwischen einer Oberseite des thermoelektrischen Bauelementes 1 und einer Unterseite des thermoelektrischen Bauelementes 1 ein Temperaturgefälle von "warm" nach "kalt". Auf Grund dieses Temperaturgefälles ist es möglich, das thermoelektrische Bauelement 1 als thermoelektrischen Generator zu nutzen, so dass zwischen den Ausgängen des thermoelektrischen Bauelementes eine Spannung anliegt. Dies ist durch "Minus"- und "Plus"-Zeichen in Fig. 1 angedeutet.

Andererseits ist es aber auch möglich, mit dem gleichen Aufbau in Fig. 1 durch Anlegen einer externen Spannung und den im Stromkreis durch das thermoelektrische Bauelement 1 fließenden Strom ein Temperaturgefälle zwischen der Oberseite und der Unterseite des thermoelektrischen Bauelementes 1 zu erzeugen. Das thermoelektrische Bauelement 1 wird somit als Peltier-Element genutzt.

Zur Kontaktierung der thermoelektrischen Schenkelpaare mit dem elektrisch leitfähigen Kontaktmaterial 4 können beispielsweise Lötverfahren oder mechanische Verfahren zum Einsatz kommen.

Beim Löten erfolgt die Aufbringung einer Lötpaste oder eines Flüssiglotes üblicherweise im Siebdruckverfahren. Alternativ kann ein Lot durch Folienformteile aufgebracht werden. Weitere Lotbeschichtungen werden mittels Aufdampfen, Sputtern, Plasmaspritzen oder galvanischer Verfahren hergestellt.

Nachteil einer Kontaktierung mittels Lötverfahren ist, dass der Erweichungspunkt des Lotes über der Betriebstemperatur des thermoelektrischen Bauelementes liegen muss. Liegt der Erweichungspunkt des Lotes unterhalb der Betriebstemperatur des thermoelektrischen Bauelementes, wird der Einsatzbereich des thermoelektrischen Bauelementes eingeschränkt, da es bei höheren Temperaturen zur Erweichung der Kontaktverbindungen und somit zur Zerstörung des Bauelementes kommen kann. Lote für thermoelektrische Anwendungen im Bereich zwischen 300° C und 450° C sind nicht verfügbar.

Überdies zeigen die für thermoelektrische Bauelemente verwendbaren Lote bei Betriebstemperaturen über 250° C weitere Mängel, wie z.B. Sprödigkeit. Grundsätzlich entsteht zudem durch die Lotschicht unweigerlich ein zusätzlicher elektrischer und thermischer Widerstand, der die Effizienz des thermoelektrischen Bauelementes weiter reduziert.

Bei mechanischen Verbindungsverfahren, beispielsweise dem Einsintern von elektrisch leitenden Geflechten in thermoelektrisches Material oder dem Anpressen elektrischer Kontakte an das thermoelektrische Material ist die aufwendige Herstellung der thermoelektrischen Bauelemente von Nachteil. Zudem weisen mechanisch angepresste Kontakte schlechte elektrische und thermische Eigenschaften auf, wodurch sich die Effizienz derartiger thermoelektrischer Bauelemente verringert.

Ein gattungsgemäßes thermoelektrisches Bauelement ist aus WO 2007/002337 A2 bekannt, mit zumindest einem thermoelektrischen Schenkelpaar, das einen n-Schenkel und einen p-Schenkel aufweist, und das mit zumindest einem elektrisch leitfähigen Kontaktmaterial verschweißt ist.

Es ist Aufgabe der vorliegenden Erfindung, ein Verfahren zur Herstellung eines thermoelektrischen Bauelementes anzugeben, durch das Schenkel kostengünstig und zuverlässig mit dem thermoelektrisch leitfähigen Kontaktmaterial kontaktiert werden können, sowie ein effizientes thermoelektrisches Bauelement.

Erfindungsgemäß gelöst wird diese Aufgabe durch ein Verfahren mit den Merkmalen des Anspruches 1.

Dabei tritt eine von den Schweißparametern und Materialien abhängige physikalischchemische Reaktion auf, wobei sich das Kontaktmaterial bzw. eine darauf befindliche Schicht mit dem Schenkelmaterial bzw. einer darauf befindlichen Reaktionsschicht verbindet.

Neben der leichten Automatisierbarkeit des gesamten Verfahrens ist es hierdurch möglich, Schweißverfahren, Schweißwerkzeuge und Schweißparameter auf die jeweiligen Schenkeleigenschaften und das in Verbindung zu bringende elektrisch leitfähige Kontaktmaterial zu optimieren. Durch die nur kurzzeitige thermische Belastung, die beim Schweißen der einzelnen Schenkel auftritt, erfolgt keine Veränderung der thermoelektrischen Eigenschaften der Schenkelmaterialien. Insbesondere kommt es nicht zum Verdampfen von Material oder zur Oxidation.

Vorzugsweise werden die Schweißparameter für die Verschweißung des n-Schenkels und die Schweißparameter für die Verschweißung des p-Schenkels unabhängig voneinander eingestellt. Somit es möglich, für jedes zu verschweißende Schenkelmaterial, bzw. für jede zu verschweißende Materialpaarung aus Schenkelmaterial und Kontaktmaterial, optimale Parametereinstellungen, beispielsweise Stromfluss und/oder Haltezeit und/oder Vorstrom und/oder Aufwärmzeit und/oder Anpressdruck für das Schweißverfahren zu wählen.

Gemäß einem bevorzugten Ausführungsbeispiel weisen die Schenkel zumindest an einem ihrer Enden in Längsrichtung Kontaktflächen auf, die in Anlage mit dem Kontaktmaterial gebracht werden, und die Verschweißung des n-Schenkels und/oder die Verschweißung des p-Schenkels erfolgt auf der Kontaktfläche und/oder seitlich der Kontaktfläche des jeweiligen Schenkels. Hierdurch entsteht eine maximal mögliche Kontaktfläche zwischen dem elektrisch leitfähigen Kontaktmaterial und den Kontaktflächen der jeweiligen Schenkel, was zu einem niedrigen Kontaktwiderstand des thermoelektrischen Bauelementes führt.

Gemäß einem weiteren bevorzugten Ausführungsbeispiel wird vor und/oder während dem jeweiligen Schweißschritt das Kontaktmaterial durch zumindest eine Schweißelektrode auf den zu verschweißenden Schenkel gepresst. Eine separate Fixierung des elektrisch leitfähigen Kontaktmaterials ist somit nicht erforderlich.

Vorzugsweise werden der n-Schenkel und der p-Schenkel des Schenkelpaares durch Spaltschweißen mit dem Kontaktmaterial verschweißt.

Weiterhin vorzugsweise wird das Kontaktmaterial mit dem entsprechenden Schenkel in Anlage gebracht, und ein Spalt einer das Kontaktmaterial kontaktierenden Spaltelektrode wird entsprechend einer Breite des zu verschweißenden Schenkels eingestellt. Hierdurch ist ein genauer Energieeintrag zur Ausbildung der Schweißverbindung möglich.

Ebenso ist es möglich, dass das Kontaktmaterial mit dem entsprechenden Schenkel in Anlage gebracht wird, und dass ein Spalt einer das Kontaktmaterial kontaktierenden Spaltelektrode breiter eingestellt wird als eine Breite des zu verschweißenden Schenkels.

Vorzugsweise umschließt das Kontaktmaterial ein Ende des zu verschweißenden Schenkels zumindest teilweise in einer Radialrichtung des Schenkels, und die Spaltelektrode kontaktiert das Kontaktmaterial in Radialrichtung des zu verschweißenden Schenkels. Hierdurch ist es möglich, dass der Energieeintrag zur Verschweißung von der Seite erfolgt, wobei die Spaltelektrode an das Kontaktmaterial angelegt oder angepresst werden kann.

Gemäß einem weiteren bevorzugten Ausführungsbeispiel werden die zu verschweißenden Schenkel und/oder das Kontaktmaterial vor der Verschweißung vorgewärmt. Hierdurch werden Spannungen im Material auf Grund von Temperaturschocks verhindert.

Gemäß einem weiteren bevorzugten Ausführungsbeispiel weist das thermoelektrische Bauelement mehrere Schenkelpaare auf, wobei aus einer Auswahl von Schenkelpaaren zuerst die n-Schenkel und anschließend die entsprechenden p-Schenkel mit dem Kontaktmaterial verschweißt werden. Gleichsam ist es auch möglich, dass das thermoelektrische Bauelement mehrere Schenkelpaare aufweist, wobei aus einer Auswahl von Schenkelpaaren zuerst die p-Schenkel und anschließend die entsprechenden n-Schen-kel mit dem Kontaktmaterial verschweißt werden. Bei beiden Möglichkeiten können somit mehrere n-Schenkel bzw. mehrere p-Schenkel parallel verschweißt werden, wodurch sich die zur Herstellung des thermoelektrischen Bauelementes benötigte Zeit verringert.

Besonders bevorzugt ist es, wenn das thermoelektrische Bauelement mehrere Schenkelpaare aufweist und alle n-Schenkel gleichzeitig mit dem Kontaktmaterial verschweißt werden. Ebenso ist es besonders bevorzugt, wenn das thermoelektrische Bauelement mehrere Schenkelpaare aufweist, und alle p-Schenkel gleichzeitig mit dem Kontaktmaterial verschweißt werden. Hierdurch wird die zur Herstellung des thermoelektrischen Bauelementes benötigte Zeit minimiert, wenn zuerst alle n-Schenkel und anschließend alle p-Schenkel verschweißt werden, bzw. umgekehrt.

Weiterhin ist es denkbar, dass alle n- und p-Schenkel separat, aber gleichzeitig mit dem Kontaktmaterial verschweißt werden.

Weitere bevorzugte Ausführungsbeispiele des erfindungsgemäßen Verfahrens sind in den weiteren abhängigen Ansprüchen dargelegt.

Die vorgenannte Aufgabe wird weiterhin erfindungsgemäß gelöst durch ein thermoelektrisches Bauelement mit den Merkmalen des Anspruches 14. Hierdurch wird die Kontaktfläche zwischen dem Kontaktmaterial und dem Schenkel vergrößert und der Kontaktwiderstand verringert.

Vorzugsweise weisen die Schenkel unterschiedliche Dimensionen auf. In Abhängigkeit von seinem Einsatzbereich lässt sich die Dicke des thermoelektrischen Bauelementes somit variieren, so dass das besagte thermoelektrische Bauelement effizient genutzt werden kann.

Vorzugsweise ist das elektrisch leitfähige Kontaktmaterial mit einem elektrisch leitfähigen Material beschichtet ist.

Gemäß einem weiteren bevorzugten Ausführungsbeispiel weist das thermoelektrische Bauelement mehrere Schenkelpaare auf, deren Schenkel über das Kontaktmaterial elektrisch in Schenkel und einen p-Schenkel aufweist, und das mit zumindest einem elektrisch leitfähigen Kontaktmaterial verschweißt ist, wobei das elektrisch leitfähige Kontaktmaterial beschichtet ist. Hierdurch wird eine besonders zuverlässige elektrische Verbindung zwischen den Schenkeln und dem Kontaktmaterial gewährleistet.

Die vorgenannte Aufgabe wird weiter erfindungsgemäß gelöst durch ein thermoelektrisches Bauelement mit zumindest einem thermoelektrischen Schenkelpaar, das einen n-Schenkel und einen p-Schenkel aufweist, und das mit zumindest einem elektrisch leitfähigen Kontaktmaterial verschweißt ist, wobei die Schenkel unterschiedliche Dimensionen aufweisen. In Abhängigkeit von seinem Einsatzbereich lässt sich die Dicke des thermoelektrischen Bauelementes somit variieren, so dass das besagte thermoelektrische Bauelement effizient genutzt werden kann.

Die vorgenannte Aufgabe wird ferner erfindungsgemäß gelöst durch ein thermoelektrisches Bauelement mit zumindest einem thermoelektrischen Schenkelpaar, das einen n-Schenkel und einen p-Schenkel aufweist, und das mit zumindest einem elektrisch leitfähigen Kontaktmaterial verschweißt ist, wobei das elektrisch leitfähige Kontaktmaterial ein Ende des verschweißten Schenkels zumindest teilweise in Radialrichtung desselben umschließt. Hierdurch wird die Kontaktfläche zwischen dem Kontaktmaterial und dem Schenkel vergrößert und der Kontaktwiderstand verringert.

Die vorgenannte Aufgabe wird außerdem erfindungsgemäß gelöst durch ein thermoelektrisches Bauelement mit zumindest einem thermoelektrischen Schenkelpaar, das einen n-Schenkel und einen p-Schenkel aufweist, und das mit zumindest einem elektrisch leitfähigen Kontaktmaterial verschweißt ist, wobei das elektrisch leitfähige Kontaktmaterial in Längsrichtung des verschweißten Schenkels mit einer Kontaktfläche desselben verschweißt ist. Auch dieses thermoelektrische Bauelement weist eine großflächige Kontaktfläche zwischen dem Kontaktmaterial und dem jeweiligen Schenkel auf, wodurch ein niedriger Kontaktwiderstand erreicht wird.

Vorzugsweise ist das elektrisch leitfähige Kontaktmaterial mit einem elektrisch leitfähigen Material beschichtet ist.

Gemäß einem weiteren bevorzugten Ausführungsbeispiel weist das thermoelektrische Bauelement mehrere Schenkelpaare auf, deren Schenkel über das Kontaktmaterial elektrisch in Reihe und thermisch parallel verbunden sind. Hierdurch lassen sich kompakte thermoelektrische Bauelemente von großer Leistungsfähigkeit realisieren.

Vorzugsweise sind die n- und p-Schenkel eines Schenkelpaares auf einer Seite des thermoelektrischen Bauelementes miteinander über das Kontaktmaterial elektrisch verbunden, und auf der gegenüberliegenden Seite des thermoelektrischen Bauelementes sind der n-Schenkel des vorgenannten Schenkelpaares mit einem anderen benachbarten p-Schenkel und der p-Schenkel des vorgenannten Schenkelpaares mit einem anderen benachbarten n-Schenkel elektrisch verbunden.

Vorzugsweise ist zwischen benachbarten Schenkeln eine mechanische Stabilisierung eingebracht. Ein derartiges thermoelektrisches Bauelement ist äußerst robust und lässt sich auch in vibrierenden Umgebungen einsetzen, ohne dass es zu einem Versagen der Schweißverbindungen kommt.

Gemäß einem weiteren bevorzugten Ausführungsbeispiel weist zumindest einer der Schenkel an einem oder beiden Enden oder Stirnflächen zumindest eine zusätzliche Schicht als Diffusionsbarriere und/oder Haftschicht und/oder zur Reduktion des Übergangswiderstandes zum Kontaktmaterial auf. Ebenso ist es möglich, dass das Kontaktmaterial zumindest eine zusätzliche Schicht als Diffusionsbarriere und/oder Haftschicht und/oder zur Reduktion des Übergangswiderstandes zu dem jeweiligen Schenkel aufweist.

Vorzugsweise ist das thermoelektrische Bauelement mechanisch flexibel. Während Lötverbindungen unter Biegebeanspruchungen relativ schnell brechen, sind Schweißverbindungen wesentlich widerstandsfähiger, so dass sich ein flexibles thermoelektrisches Bauelement in unterschiedlichen Umfeldern, z.B. an benachbarte Thermoleiter anpassen lässt.

Weiter bevorzugte Ausführungsbeispiele des erfindungsgemäßen thermoelektrischen Bauelementes sind in den weiteren abhängigen Ansprüchen dargelegt.

Die vorliegende Erfindung wird nachfolgend anhand von bevorzugten Ausführungsbeispielen in Verbindung mit den zugehörigen Figuren näher erläutert. In diesen zeigen:
- Fig. 1: eine schematische Darstellung eines grundsätzlichen Aufbaus eines thermoelektrischen Bauelementes zur Erläuterung des Funktionsprinzips,
- Fig. 2: eine schematische Darstellung eines Schenkelpaares eines thermoelektrischen Bauelementes,
- Fig. 3: eine schematische Darstellung eines thermoelektrischen Bauelementes, das um einen Thermoleiter angeordnet ist,
- Fig. 4: eine schematische Darstellung eines thermoelektrischen Bauelementes in Flachbauweise,
- Fig. 5: eine schematische Darstellung eines thermoelektrischen Bauelementes in Flachbauweise mit einer mechanischen Stabilisierung,
- Fig. 6-9: eine schematische Darstellung eines Verfahrens zur Herstellung eines thermoelektrischen Bauelementes, und
- Fig. 10-12: unterschiedliche Spaltschweißungen zur Kontaktierung von p- und n-Schenkeln mit elektrisch leitfähigen Kontaktmaterial.

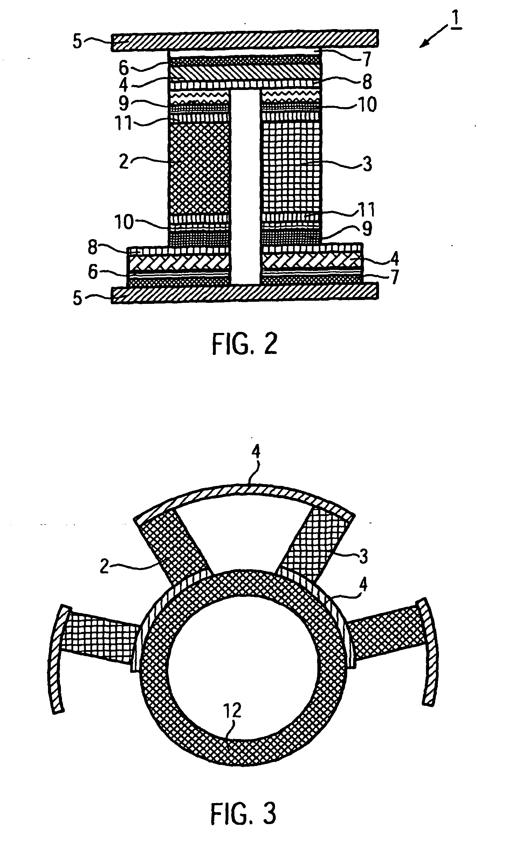

Neben der bereits in der Beschreibungseinleitung beschriebenen Fig. 1 zeigt Fig. 2 eine schematische Darstellung eines bevorzugten Ausführungsbeispiels eines Schenkelpaares eines thermoelektrischen Bauelementes 1.

In der nachfolgenden Beschreibung werden gleiche Bezugszeichen für gleiche Merkmale verwendet, wobei aus Gründen einer klaren Darstellung nicht für alle gleichartigen Merkmale, insbesondere für alle Schenkel der verschiedenen Ausführungsformen von thermoelektrischen Bauelementen 1, Bezugszeichen in den Figuren angegeben sind. Vielmehr sind nur einzelne Schenkel exemplarisch mit den jeweiligen Bezugszeichen versehen.

Das thermoelektrische Bauelement 1 in Fig. 2 weist ein Schenkelpaar, bestehend aus einem n-Schenkel 2 und einem p-Schenkel 3 auf. Mittels Verschweißungen sind der n-Schenkel 2 und der p-Schenkel 3 mit elektrisch leitfähigem Kontaktmaterial 4 elektrisch leitend kontaktiert. Im oberen Bereich der Fig. 2 sind die beiden Schenkel 2, 3 durch einen Streifen von elektrisch leitfähigem Kontaktmaterial 4 miteinander verbunden. Im unteren Bereich der Fig. 2 ist jeder der beiden Schenkel 2, 3 mit einem separaten Streifen von elektrisch leitfähigem Kontaktmaterial 4 verbunden.

An letztgenannten Streifen kann bereits eine Spannung abgegriffen werden, wenn es sich bei dem thermoelektrischen Bauelemente 1 um einen thermoelektrischen Generator oder einen Temperatursensor handelt. Alternativ kann an diesen Stellen auch bereits die Kontaktierung mit einer Stromquelle erfolgen, wenn das thermoelektrische Bauelement 1 als Peltier-Element genutzt wird.

Gemäß einem bevorzugten Ausführungsbeispiel sind die elektrisch leitfähigen Kontaktmaterialien 4 im unteren Bereich der Fig. 2 jedoch mit weiteren benachbarten Schenkeln 2, 3 elektrisch leitend verbunden. Das heißt, dass in Fig. 2 der n-Schenkel 2 auf seiner linken Seite mit einem nicht gezeigten weiteren p-Schenkel verbunden ist, während der p-Schenkel 3 auf seiner rechten Seite mit einem weiteren nicht gezeigten n-Schenkel elektrisch leitend verbunden ist. Neben Fig. 1 finden sich solche Anordnungen auch in den nachfolgend beschriebenen Figuren 3 bis 5.

Somit sind die n- und p-Schenkel 2, 3 des in Fig. 2 gezeigten Schenkelpaares auf der oberen Seite des thermoelektrischen Bauelementes 1 miteinander über das Kontaktmaterial 4 elektrisch verbunden. Auf der gegenüberliegenden unteren Seite des thermoelektrischen Bauelementes 1 ist der n-Schenkel 2 des gezeigten Schenkelpaares vorzugsweise mit einem anderen benachbarten, nicht gezeigten p-Schenkel verbunden, und der p-Schenkel 3 des gezeigten Schenkelpaares ist vorzugsweise mit einem anderen benachbarten, nicht gezeigten n-Schenkel verbunden. Hierdurch sind die einzelnen Schenkel 2, 3 über das Kontaktmaterial 4 elektrisch in Reihe und thermisch parallel verbunden. Vorzugsweise weist das thermoelektrische Bauelement 1 mehrere Schenkelpaare auf, deren Schenkel 2, 3 über das Kontaktmaterial elektrisch in Reihe und thermisch parallel verbunden sind, wobei die jeweiligen Schenkel 2,3 in verschiedenen Raumrichtungen miteinander kontaktiert werden können.

In den dargestellten Ausführungsbeispielen ist die Form der Schenkel 2, 3 im Wesentlichen quaderförmig. Jedoch sind auch andere Schenkelformen, beispielsweise rotationssymmetrische, insbesondere runde Schenkelquerschnitte denkbar. Die Dimensionen der Schenkel 2, 3 können beliebig variieren.

Vorzugsweise ist zumindest einer der Schenkel 2, 3 an einem oder beiden Enden oder Stirnflächen zumindest mit einer zusätzlichen Schicht versehen. Beispielsweise kann es sich hierbei um eine Schicht zur Reduktion des Übergangswiderstandes 9 und/oder eine Diffusionsbarriere 10 und/oder eine Haftschicht 11 handeln. Diese Schichten können in verschiedenen Reihenfolgen und Stärken auf die jeweiligen Schenkel 2, 3, insbesondere an deren Kontaktflächen zu dem Kontaktmaterial 4, aufgebracht werden. Beispielsweise eignet sich zur Aufbringung ein Verfahren mittels galvanischer Abscheidung.

Vorzugsweise kann das elektrisch leitfähige Kontaktmaterial 4 zusätzlich oder alternativ mit einer oder mehreren Schichten beschichtet sein. Hierbei kann es sich um eine separate Metallisierung 7 handeln und/oder weitere Diffusionsbarrieren 6, 8. In dem dargestellten Ausführungsbeispiel weist das elektrisch leitfähige Kontaktmaterial 4 neben einer zusätzlichen Metallisierung 7 eine innenliegende Diffusionsbarriere 8 zu den jeweiligen n- und p-Schenkeln 2, 3 auf, sowie eine außenliegende Diffusionsbarriere 6 zwischen der Metallisierung 7 und dem eigentlich elektrisch leitfähigen Kontaktmaterial 4. Auch eine separate Haftschicht ist denkbar, wobei sämtliche Schichten in anderen Reihenfolgen angeordnet werden können. Zur Aufbringung dieser Schichten auf das Kontaktmaterial 4 eignet sich wiederum vorzugsweise ein Verfahren mittels galvanischer Abscheidung.

Durch das Vorsehen von zusätzlichen Schichten auf dem elektrisch leitfähigen Kontaktmaterial 4 und/oder den Schenkeln 2, 3 lässt sich eine mechanisch stabile sowie elektrisch und thermisch gut leitende Verbindung erzielen. Zudem dienen diese Beschichtungen zur Verringerung des thermischen und elektrischen Übergangswiderstandes sowie zur Beseitigung anderer störender Effekte, wie z. B. thermischer und mechanischer Verspannungen. Insbesondere kann durch die Abstimmung der jeweiligen Schichten hinsichtlich ihrer Materialzusammensetzung eine Anpassung des thermischen Ausdehnungskoeffizienten erfolgen. Auf dem elektrisch leitfähigen Kontaktmaterial 4 ist es zudem denkbar, eine Isolationsschicht zur elektrischen Isolierung der Bereiche um die Schenkelkontaktstellen vorzusehen, insbesondere bei sehr dünnen thermoelektrischen Bauelementen 1.

Ferner ist in Fig. 2 ein optionales Substrat 5 gezeigt, das das thermoelektrische Bauelement 1 nach außen hin elektrisch isoliert. Jedoch ist es auch denkbar, dass das thermoelektrische Bauelement 1 nach außen hin offen ist, beispielsweise wenn ein angrenzender Thermoleiter 12 selbst aus einem elektrisch isolierenden Material besteht.

Die n- und p-Schenkel 2, 3 weisen vorzugsweise zumindest eines der folgenden Elemente bzw. eine Zusammensetzung der folgenden Elementen auf: Ta, W, Mo, Nb, Ti, Cr, Pd, V, Pt, Rh, Re, Cu, Ag, Ni, Fe, Co, Al, In, Sn, Pb, Te, Sb, Bi, Se, S, Au, Zn, Si und Ge. Vorteilhaft ist es, wenn die Schenkel 2, 3 im Wesentlichen Zusammensetzungen aus Elementen der vierten und sechsten Hauptgruppe aufweisen, insbesondere beliebige Kombinationen aus [Pb, Sn, Ge] und [S, Se, Te], wie z.B. PbTe, PbSe, PbS, SnTe, GeTe und GeSe. Vorzugsweise weist zumindest einer der Schenkel 2, 3 ein Chalkogenid-basiertes Material auf.

Ebenso ist es denkbar, dass die n- und p-Schenkel 2, 3 im Wesentlichen Zusammensetzungen aus Elementen der fünften und sechsten Hauptgruppe aufweisen, insbesondere Zusammensetzungen aus [Bi, Sb]₂ und [S, Se, Te]₃, wie z.B. Bi₂S₃, Bi₂Te₃, Bi₂Se₃, Sb₂S₃, Sb₂Se₃ und Sb₂Te₃.

Ebenso ist es denkbar, dass die Schenkel 2, 3 Materialien auf SiGe-Basis, Materialien auf Skutterudit-Basis, Materialien auf Halbheusler-Basis, Materialien auf Oxid-Basis, Materialien auf Antimon-Basis, Materialien auf Clathrat-Basis oder Materialien auf Bor-Basis aufweisen.

Auch ist es vorteilhaft, wenn die n- und p-Schenkel 2, 3 Materialien aus der Kohlenstoffgruppe, d.h. der vierten Hauptgruppe des Periodensystems, auch in Zusammensetzung aufweisen, d.h. C, Si, Ge, Sn und Pb. Vorteilhaft erscheinen für die Schenkel 2, 3 ebenso Nanokomposite.

Für das elektrisch leitfähige Kontaktmaterial 4 sind folgende Elemente bzw. eine Zusammensetzung der folgenden Elemente bevorzugt: Ta, W, Mo, Nb, Ti, Cr, Pd, V, Pt, Rh, Re, Cu, Ag, Ni, Fe, Co, Al, In, Sn, Pb, Te, Sb, Bi, Se, S, Au, Zn, Si und Ge. Gleiches gilt für die Beschichtungen des Kontaktmaterials 4.

Insbesondere ist es vorteilhaft, wenn das Kontaktmaterial 4 einen Streifen oder Draht aus Ta, W, Mo, Nb, Ti, Cr, Pd, V, Pt, Rh, Re, Cu, Ag, Ni, Fe, Co, Al, In, Sn, Pb, Te, Sb, Bi, Se, S, Au, Zn, Si oder Ge alleine oder in Kombination mit einem oder mehreren anderen Elementen aufweist. Auch mehrere aufeinanderliegende oder nebeneinanderliegende Streifen oder Drähte aus Kontaktmaterial 4 sind denkbar. Ebenso ist es möglich, dass eine auf dem Kontaktmaterial aufgebrachte Schicht eines oder mehrere der vorgenannten Elemente aufweist. Hierbei kann es sich insbesondere um eine Reaktionsschicht handeln, die mit dem jeweiligen Schenkel 2, 3 und/oder einer auf diesem Schenkel befindlichen Reaktionsschicht bei der Verschweißung physikalisch-chemisch reagiert.

Vorzugsweise sind alle n-Schenkel 2 und p-Schenkel 3 mit den entsprechenden Streifen oder Drähten aus elektrisch leitfähigem Kontaktmaterial 4 verschweißt. Jedoch ist es auch denkbar, nur auf einer Seite des thermoelektrischen Bauelementes 1 die Schenkel 2, 3 mit den Streifen oder Drähten aus elektrisch leitfähigem Kontaktmaterial 4 zu verschweißen, beispielsweise auf der oberen Seite mit Bezug auf Fig. 2. Auf der gegenüberliegenden Seite können die Schenkel 2, 3 auch durch ein anderes Verbindungsverfahren (Lötverfahren, mechanisches Verbindungsverfahren) mit den jeweiligen Streifen oder Drähten des elektrisch leitfähigen Kontaktmaterials 4 verbunden werden.

Vorzugsweise können die n- und p-Schenkel 2, 3 unterschiedliche Dimensionen aufweisen, um das thermoelektrische Bauelement 1 an unterschiedliche Umfelder anpassen zu können. Ebenso ist es vorteilhaft, wenn das elektrisch leitfähige Kontaktmaterial 4 in Längsrichtung L des jeweiligen Schenkels 2, 3 vollständig mit einer Kontaktfläche, insbesondere Stirnfläche, desselben verschweißt ist. Weiterhin ist es vorteilhaft, wenn das elektrisch leitfähige Kontaktmaterial 4 ein Ende des verschweißten Schenkels 2, 3 zumindest teilweise in Radialrichtung R desselben umschließt. Vorgenannte Ausführungsbeispiele können auch beliebig miteinander-kombiniert-werden.

In Fig. 3 ist eine schematische Darstellung eines thermoelektrischen Bauelementes 1 um einen Thermoleiter 12 gezeigt. Im Gegensatz zu dem in Fig. 2 gezeigten Ausführungsbeispiel weist das Ausführungsbeispiel von Fig. 3 kein elektrisch isolierendes Substrat 5 auf, da der Thermoleiter 12 selbst vorzugsweise elektrisch isolierend ist. Der Thermoleiter 12 ist beispielsweise rohrförmig und weist vorzugsweise einen runden Querschnitt auf. Vorzugsweise weist das thermoelektrische Bauelement 1 daher eine gewölbte, insbesondere ring- oder rohrförmige Form auf.

Besonders vorteilhaft ist es, wenn das thermoelektrische Bauteil 1 mechanisch flexibel ist und dem Querschnitt des Thermoleiters 12 anpaßbar ist. Durch die Verschweißungen zwischen dem Kontaktmaterial 4 und den Schenkeln 2, 3 ist es möglich, das flexible thermoelektrische Bauelement 1 unterschiedlichen Umfeldern und Einbausituationen anzupassen, da die Schweißverbindungen im Gegensatz zu konventionellen Lötverbindungen wesentlich belastbarer sind und weniger schnell brechen.

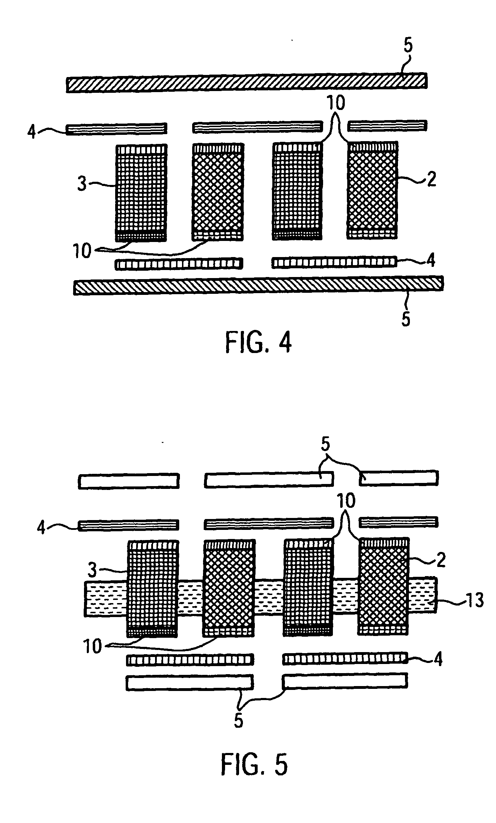

Die Fig. 4 und 5 zeigen jeweils thermoelektrische Bauelemente 1 in einer flachen Ausführung. Die Kontaktflächen der Schenkel 2, 3 sind in Längsrichtung L derselben jeweils mit Diffusionsbarrieren 10 versehen. Im Unterschied zu Fig. 4 weist das Ausführungsbeispiel in Fig. 5 kein durchgehendes elektrisch isolierendes äußeres Substrat 5 auf, sondern Abschnitte dieses Substrats 5. Die Abschnitte des Substrats 5 bedecken jeweils die Streifen des elektrisch leitfähigen Kontaktmaterials 4, so dass die elektrische Isolierung nach außen gewährleistet ist.

Dadurch ist es möglich, das thermoelektrische Bauelement 1 zu verformen, um es geometrisch schwierigen Einbausituationen anzupassen. Zur Verstärkung ist hierzu im Inneren des thermoelektrischen Bauelementes 1 eine mechanische Stabilisierung 13 vorgesehen, die die jeweiligen Schenkel 2, 3 umschließt und benachbarte Schenkel voneinander trennt. Diese mechanische Stabilisierung 13 kann in dem thermoelektrischen Bauelement 1 verbleiben, kann jedoch auch nach dessen Herstellung entfernt werden. Im erstgenannten Fall sollte sie elektrisch nicht und thermisch nur sehr schlecht leitend sein, im zweitgenannten Fall spielt die thermische und elektrische Leitfähigkeit der mechanischen Stabilisierung 13 keine Rolle.

Verbleibt die mechanische Stabilisierung 13 als Matrixmaterial im thermoelektrischen Bauelement 1, dient sie nicht nur zur Stabilisierung, sondern verhindert beispielsweise auch die Verunreinigung oder Änderung der chemischen Zusammensetzung der Schenkel 2, 3. Vorzugsweise kommen hierfür Keramiken, Gläser, Porzellan oder Kunststoffe zum Einsatz. Insbesondere beim Einsatz von elastisch verformbaren Kunststoffen als Matrixmaterial für die mechanische Stabilisierung 13 ist es möglich, das derart stabilisierte thermoelastische Bauelement 1 der Einbausituation flexibel anzupassen.

Das Kontaktmaterial 4 besitzt vorzugsweise Dicken zwischen 1 µm und 1 mm sowie Breiten zwischen 10 µm und 100 mm. Zum Verbinden von zwei Schenkeln 2, 3 können einer oder mehrere Streifen des Kontaktmaterials 4 nebeneinander oder übereinander verwendet werden.

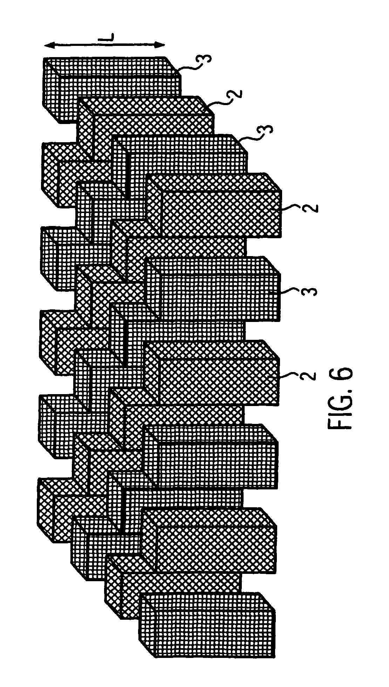

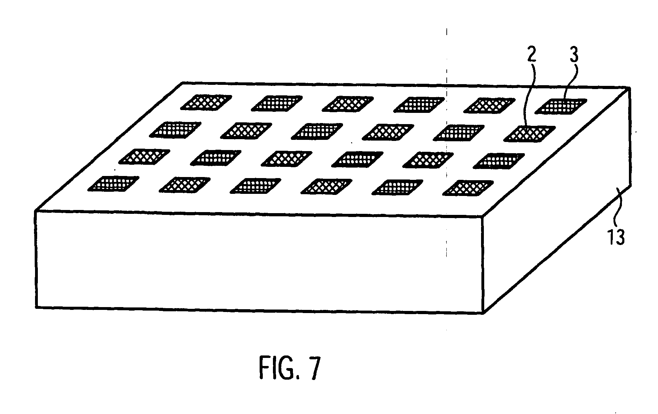

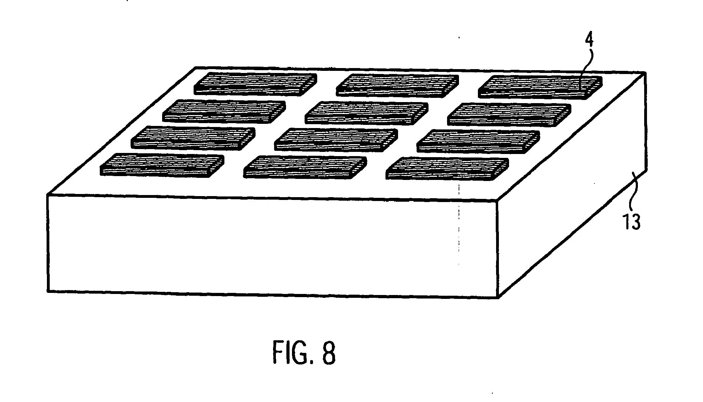

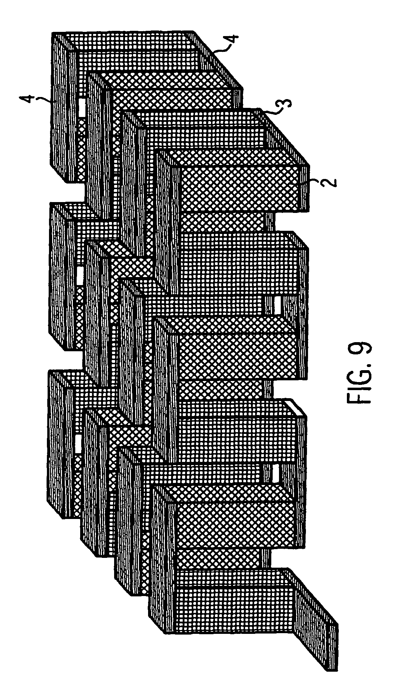

In den Fig. 6 bis 9 ist in einer schematischen Darstellung ein bevorzugtes Verfahren zur Herstellung eines thermoelektrischen Bauelementes 1 gezeigt. In diesen Figuren sind das thermoelektrische Bauelement 1 bzw. Teile des thermoelektrischen Bauelementes 1 dreidimensional dargestellt. Das flächige Kontaktmaterial 4 erstreckt sich in den Figuren 8 und 9 entlang der Grundflächen des herzustellenden thermoelektrischen Bauelementes 1, d.h. entlang seiner Länge und Breite. Längsachsen der Schenkel 2, 3 definieren die Höhe des herzustellenden thermoelektrischen Bauelementes 1, wobei sich die Schenkel 2, 3 in Figur 6 in Längsrichtung L erstrecken.

In Fig. 6 werden die n- und p-Schenkel 2, 3 wunschgemäß bereits im Hinblick auf die spätere Einbausituation angeordnet. Hierbei ist es auch möglich, Schenkel 2, 3 mit unterschiedlichen Schenkellängen zu verwenden. Bezüglich der Zusammensetzung der Schenkel und deren Form wird auf die vorangegangene Beschreibung verwiesen.

Anschließend werden die Schenkel 2, 3 vorzugsweise von einem Matrixmaterial als mechanische Stabilisierung 13 wie zuvor beschrieben, umgeben.

Zuvor beschriebenes elektrisch leitfähiges Kontaktmaterial 4 wird jeweils zur Verbindung von zwei benachbarten n- und p-Schenkeln 2, 3 auf der Oberseite und der nicht gezeigten Unterseite mit den besagten Schenkeln verschweißt. Die Verschweißung von n- und p-Schenkel kann zeitlich aufeinanderfolgend erfolgen. Es ist auch denkbar, dass alle n- und p-Schenkel 2, 3 separat, aber gleichzeitig mit dem Kontaktmaterial 4 verschweißt werden.

Als Schweißverfahren kommt vorzugsweise das Widerstandsschweißen, beispielsweise das Spältschweißen, das Punktschweißen, das Buckelschweißen oder das Rollenschweißen zum Einsatz. Vorzugsweise werden diese Schweißverfahren in einer Schutzgasatmosphäre, entweder in einem Inertgas oder in einem Aktivgas, durchgeführt, um eine Verunreinigung der Schweißstelle, insbesondere durch Oxide, zu verhindern. Ebenso ist es denkbar, das Schweißverfahren in einem Vakuum durchzuführen.

Andere Schweißverfahren, wie beispielsweise das Lichtbogenschweißen, das Schutzgasschweißen, das Laserstrahlschweißen, das Elektronenstrahlschweißen, das Plasmaschweißen oder das Wasserstoffschweißen sind möglich. Insbesondere sind jedoch das Spaltschweißen, vorzugsweise als Engspaltschweißen bzw. Schutzgas-Engspaltschweißen vorteilhaft, worauf im Folgenden noch eingegangen wird. Auch Metall-Schutzgasschweißverfahren, entweder mit Inertgas oder mit Aktivgas, sind vorteilhaft. Hierbei ist insbesondere das Wolfram-Schutzgasschweißen hervorzuheben.

Bei allen Verfahren ist es möglich, die zu verschweißenden Schenkel 2, 3 und/oder das Kontaktmaterial 4 vor der Verschweißung vorzuwärmen.

Durch die Verschweißung werden stabile Kontaktierungen mit Anwendungsmöglichkeiten bis zu sehr hohen Temperaturen erreicht. Durch einen kurzzeitigen Energieeintrag in das Kontaktmaterial 4 sowie unter Umständen in ein oder mehrere darauf bzw. darunter befindliche Materialien und in das Schenkelmaterial sowie unter Umständen in ein oder mehrere darauf befindliche Materialien erfolgt die Verschweißung.

Durch das Schweißverfahren können fast alle Materialkombinationen von Kontaktmaterial und Schenkelmaterial bzw. den darauf oder darunter befindlichen Materialien miteinander verbunden werden. Somit wird eine gute Haftung erzielt und gleichzeitig können sehr hochschmelzende Materialien verbunden werden, so dass die Kontaktierung den jeweiligen thermischen Anforderungen genügt. Außerdem zeichnen sich mit dieser Technik hergestellte Kontakte durch eine gute mechanische Stabilität aus.

Durch die Möglichkeit, fast alle Materialkombinationen von Kontaktmaterial und Schenkelmaterial sowie die entsprechenden Schichtaufbauten durch Schweißen zu verbinden, ist eine Anpassung der thermischen Ausdehnungskoeffizienten und eine Vermeidung der Diffusion mittels Diffusionsbarrieren leicht realisierbar. Höhenunterschiede der einzelnen Schenkel spielen hierbei keine Rolle. Das Schweißverfahren ist aufgrund seiner Einfachheit gut automatisierbar und erreicht eine hohe Reproduzierbarkeit.

In Figur 9 wird die optionale mechanische Stabilisierung 13 entfernt, falls erforderlich. Nachfolgend kann das thermoelektrische Bauelement 1 dann noch beispielsweise auf dessen Ober- und Unterseite mit dem zuvor beschriebenen äußeren Substrat 5 versehen werden.

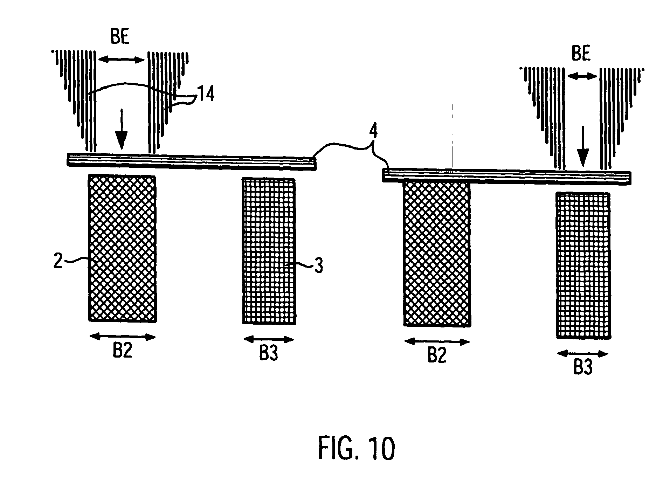

In den Figuren 10 bis 12 werden unterschiedliche Spaltschweißungen zur Kontaktierung der n- und p-Schenkel 2, 3 mit dem elektrisch leitfähigen Kontaktmaterial 4 erläutert. Das Bezugszeichen 14 bezeichnet eine Spaltelektrode, deren beide Elektrodenspitzen durch einen Spalt BE beabstandet sind. Die Breite des Spalts BE ist variabel einstellbar. Vorzugsweise weisen der n-Schenkel 2 und der p-Schenkel 3 unterschiedliche Schenkelbreiten B2 und B3 auf.

In dem in Figur 10 gezeigten Ausführungsbeispiel wird der Spalt BE der Spaltelektrode 14 entsprechend der Breite B2 des n-Schenkels 2 eingestellt. Die Spaltelektrode 14 kontaktiert das auf den Schenkeln 2, 3 liegende Kontaktmaterial 4 und presst dieses vorzugsweise auf den zu verschweißenden Schenkel 2 bzw. 3. Jedoch ist es auch denkbar, dass das Kontaktmaterial 4 durch andere Mittel bereits auf die jeweiligen Schenkel 2, 3 gepresst wird. Letztgenanntes ist insbesondere zu berücksichtigen, wenn berührungslos geschweißt wird, beispielsweise mittels Laserstrahlschweißen oder Elektronenstrahlschweißen.

Die Kontaktflächen bzw. Stirnflächen, die die Schenkel 2, 3 an ihren Enden in Längsrichtung L aufweisen, werden in Anlage mit dem Kontaktmaterial gebracht und die Verschweißung des jeweiligen Schenkels erfolgt vorzugsweise über die gesamte Kontaktfläche des besagten Schenkels 2, 3.

Die Elektroden, vorzugsweise die Elektrodenspitzen der Spaltelektrode 14 werden mit einem Anpressdruck zwischen 0,001 N/mm² und 10000 N/mm² auf das auf dem jeweiligen Schenkel befindliche Kontaktmaterial 4 gepresst. Zum Schweißen fließt ein Strom im Bereich von einem 1 µA/mm² bis zu 10kA/mm² zwischen 1 ns und 10s zwischen den beiden Elektroden durch das Kontaktmaterial 4 und den jeweils zu verschweißenden Schenkel.

Nachdem der n-Schenkel 2 auf der linken Seite von Figur 10 in einem ersten Schweißschritt verschweißt worden ist, wird der Spalt BE der Spaltelektrode 14 auf die Breite B3 des rechts befindlichen p-Schenkels 3 eingestellt und über diesem positioniert. Alternativ ist es auch möglich, die Position des thermoelektrischen Bauelementes 1 entsprechend zu ändern.

Für den zweiten, nachfolgenden Schweißschritt werden weitere Schweißparameter, wie z.B. Stromfluss, Haltezeit, Vorstrom, Aufwärmzeit und/oder Anpressdruck entsprechend dem schmaleren und aus anderem Material bestehenden p-Schenkel 3 angepaßt. Auch ist es möglich, das Schweißwerkzeug selbst zu wechseln und die Schweißparameter entsprechend anzupassen. Somit werden vorzugsweise für die Verschweißung von n- und p-Schenkeln 2, 3 mit unterschiedlicher Geometrie und/oder unterschiedlicher Zusammensetzung verschiedene Schweißparameter unabhängig voneinander eingestellt.

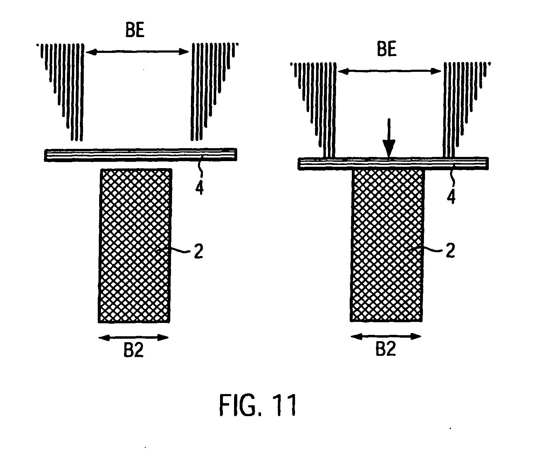

In einem weiteren bevorzugten Ausführungsbeispiel in Figur 11 wird der Spalt BE der das Kontaktmaterial 4 kontaktierenden Spaltelektrode 14 breiter eingestellt als die Breite B2 bzw. B3 des jeweils zu verschweißenden Schenkels.

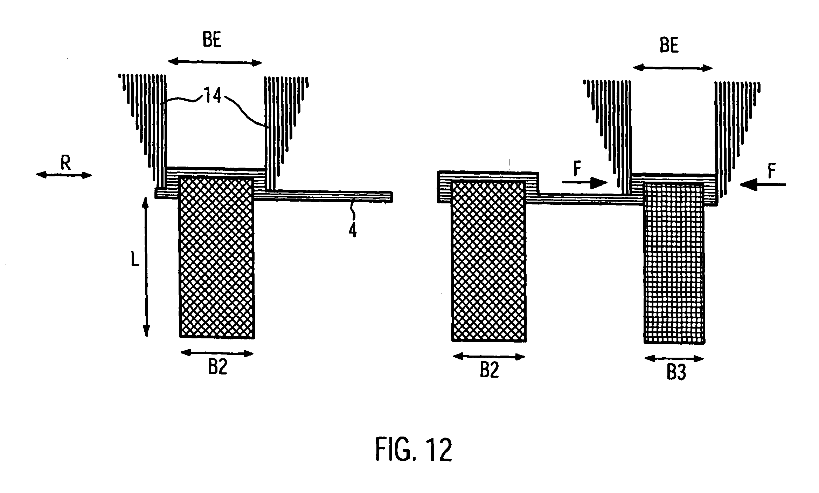

Während in den Figuren 10 und 11 die Spaltelektrode 14 das Kontaktmaterial 4 in Längsrichtung L des zu verschweißenden Schenkels 2, 3 kontaktiert, ist in Figur 12 ein weiteres Ausführungsbeispiel gezeigt, in dem das Kontaktmaterial ein Ende des zu verschweißenden Schenkels 2, 3 zumindest teilweise in einer Radialrichtung R des Schenkels 2, 3, d.h. in seiner Breite umschließt. Die Spaltelektrode 14 kontaktiert das Kontaktmaterial 4 in Radialrichtung R des zu verschweißenden Schenkels 2, 3 und beaufschlagt das Kontaktmaterial 4 mit einer Kraft F in Radialrichtung R.

Hierzu ist es vorteilhaft, wenn das Kontaktmaterial 4 mit entsprechenden Aussparungen oder Vertiefungen für die Enden der Schenkel 2, 3 vorgeformt wird. Jedoch ist es auch denkbar, diese Vertiefungen erst durch Aufpressen eines an sich ebenen Streifens von Kontaktmaterial 4 auf die jeweiligen Schenkelenden zu erreichen.

Unabhängig vom gewählten Schweißverfahren ist es vorteilhaft, wenn das thermoelektrische Bauelement 1 mehrere Schenkelpaare aufweist, so dass aus einer Auswahl von Schenkelpaaren zuerst die n-Schenkel 2 und anschließend die entsprechenden p-Schenkel 3 mit dem Kontaktmaterial 4 verschweißt werden, oder umgekehrt. Weist das thermoelektrische Bauelement 1 mehrere Schenkelpaare auf, ist es vorteilhaft, alle n-Schenkel 2 oder alle p-Schenkel 3 gleichzeitig mit dem Kontaktmaterial 4 zu verschweißen. Insbesondere ist es vorteilhaft, wenn alle n-Schenkel 2 einer Seite (Ober- oder Unterseite des thermoelektrischen Bauelementes 1) oder alle p-Schenkel 3 einer Seite gleichzeitig mit dem Kontaktmaterial 4 verschweißt werden.

Es ist auch denkbar, dass das Kontaktmaterial 4 aus mehreren Lagen vorzugsweise unterschiedlicher Materialien besteht, die miteinander und/oder dem jeweiligen Schenkel 2, 3 verbunden, insbesondere verschweißt sind. Diese mehrlagigen Kontaktmaterialien 4 weisen vorzugsweise Folien, insbesondere beschichtete Folien auf. In diesem Fall ist es möglich, das mehrlagige Kontaktmaterial 4 in einem oder mehreren Schweißschritten miteinander und/oder dem jeweiligen Schenkel 2, 3 zu verbinden bzw. zu verschweißen.

Die zuvor beschriebenen Ausführungsbeispiele betreffen ein Verfahren zur Herstellung eines thermoelektrischen Bauelementes 1 mit zumindest einem thermoelektrischen Schenkelpaar, das einen n-Schenkel 2 und einen p-Schenkel 3 aufweist, wobei beide Schenkel 2, 3 mit einem elektrisch leitfähigen Kontaktmaterial 4 verschweißt werden, wobei der n-Schenkel 2 und der p-Schenkel 3 des Schenkelpaares in separaten Schweißschritten mit dem Kontaktmaterial 4 verschweißt werden, sowie ein thermoelektrisches Bauelement 1.

## Patentansprüche

1. Verfahren zur Herstellung eines thermoelektrischen Bauelementes mit zumindest einem thermoelektrischen Schenkelpaar, das einen n-Schenkel (2) und einen p-Schenkel (3) aufweist, wobei beide Schenkel (2,3) mit einem elektrisch leitfähigen Kontaktmaterial (4) verschweißt werden, **dadurch gekennzeichnet, dass** der n-Schenkel (2) und der p-Schenkel (3) des Schenkelpaares in separaten Schweißschritten mit dem Kontaktmaterial (4) verschweißt werden.

2. Verfahren nach Anspruch 1, **dadurch gekennzeichnet, dass** Schweißparameter für die Verschweißung des n-Schenkels (2) und Schweißparameter für die Verschweißung des p-Schenkels (3) unabhängig voneinander eingestellt werden, insbesondere in einem Vakuum oder unter einer Schutzgasatmosphäre erfolgt.

3. Verfahren nach Anspruch 1 oder 2, **dadurch gekennzeichnet, dass** die Schenkel (2,3) zumindest an einem ihrer Enden in Längsrichtung (L) Kontaktflächen aufweisen, die in Anlage mit dem Kontaktmaterial (4) gebracht werden, und die Verschweißung des n-Schenkels (2) und/oder die Verschweißung des p-Schenkels (3) auf der Kontaktfläche und/oder seitlich der Kontaktfläche des jeweiligen Schenkels (2,3) erfolgt, und/oder die Verschweißung des n-Schenkels (2) und/oder die Verschweißung des p-Schenkels (3) über die gesamte Kontaktfläche des jeweiligen Schenkels (2,3) erfolgt.

4. Verfahren nach zumindest einem der Ansprüche 1 bis 3, **dadurch gekennzeichnet, dass** das Kontaktmaterial (4) aus mehreren Lagen vorzugsweise unterschiedlicher Materialien besteht, die in einem oder mehreren Schweißschritten miteinander und/oder dem jeweiligen Schenkel (2,3) verbunden werden.

5. Verfahren nach zumindest einem der Ansprüche 1 bis 4, **dadurch gekennzeichnet, dass** das Kontaktmaterial (4) oder eine darauf befindliche Schicht physikalisch-chemisch mit dem Material des p-Schenkels (3) und/oder einer darauf befindlichen Reaktionsschicht und/oder physikalisch-chemisch mit dem Material des n-Schenkels (2) und/oder einer darauf befindlichen Reaktionsschicht reagiert, und die Reaktionsschicht aus zumindest einem der Elemente Ta, W, Mo, Nb, Ti, Cr, Pd, V, Pt, Rh, Re, Cu, Ag, Ni, Fe, Co, Al, In, Sn, Pb, Te, Sb, Bi, Se, S. Au, Zn, Si oder Ge alleine oder in Kombination mit einem anderen Element besteht.

6. Verfahren nach zumindest einem der Ansprüche 1 bis 5, **dadurch gekennzeichnet, dass** vor und/oder während dem jeweiligen Schweißschritt das Kontaktmaterial (4) auf den zu verschweißenden Schenkel (2,3) gepresst wird und/oder dass vor und/oder während dem jeweiligen Schweißschritt das Kontaktmaterial (4) durch zumindest eine Schweißelektrode auf den zu verschweißenden Schenkel (2,3) gepresst wird.

7. Verfahren nach zumindest einem der Ansprüche 1 bis 6, **dadurch gekennzeichnet, dass** der n-Schenkel (2) und der p-Schenkel (3) des Schenkelpaares durch Widerstandsschweißen separat mit dem Kontaktmaterial (4) verschweißt werden und/oder der n-Schenkel (2) und der p-Schenkel (3) des Schenkelpaares durch Spaltschweißen mit dem Kontaktmaterial (4) verschweißt werden.

8. Verfahren nach Anspruch 7, **dadurch gekennzeichnet, dass** beim Spaltschweißen das Kontaktmaterial (4) mit dem entsprechenden Schenkel (2,3) in Anlage gebracht wird, und ein Spalt (BE) einer das Kontaktmaterial (4) kontaktierenden Spaltelektrode (14) entsprechend einer Breite (B2,B3) des zu verschweißenden Schenkels (2,3) eingestellt wird und/oder das Kontaktmaterial (4) mit dem entsprechenden Schenkel (2,3) in Anlage gebracht wird, und ein Spalt (BE) einer das Kontaktmaterial (4) kontaktierenden Spaltelektrode (14) breiter eingestellt wird als eine Breite (B2,B3) des zu verschweißenden Schenkels (2,3).

9. Verfahren nach Anspruch 8, **dadurch gekennzeichnet, dass** das Kontaktmaterial (4) ein Ende des zu verschweißenden Schenkels (2,3) zumindest teilweise in einer Radialrichtung (R) des Schenkels (2,3) umschließt, und die Spaltelektrode (14) das Kontaktmaterial (4) in Radialrichtung (R) des zu verschweißenden Schenkels (2,3) kontaktiert und/oder die Spaltelektrode (14) das Kontaktmaterial (4) in Längsrichtung (L) des zu verschweißenden Schenkels (2,3) kontaktiert.

10. Verfahren nach zumindest einem der Ansprüche 1 bis 9, **dadurch gekennzeichnet, dass** der n-Schenkel (2) und/oder der p-Schenkel (3) des Schenkelpaares mit dem Kontaktmaterial (4) durch Schutzgasschweißen, vorzugsweise durch Metall-Inertgas-Schweißen, Wolfram-Inertgas-Schweißen, Metall-Aktivgas-Schweißen, Plasmaschweißen oder Wasserstoffschweißen verschweißt wird/werden oder dass der n-Schenkel (2) und/oder der p-Schenkel (3) des Schenkelpaares mit dem Kontaktmaterial (4) durch Laserstrahlschweißen verschweißt wird/werden, wobei vorzugsweise die zu verschweißenden Schenkel (2,3) und/oder das Kontaktmaterial (4) vor der Verschweißung vorgewärmt werden.

11. Verfahren nach zumindest einem der Ansprüche 1 bis 10, **dadurch gekennzeichnet, dass** das thermoelektrische Bauelement mehrere Schenkelpaare aufweist, wobei aus einer Auswahl von Schenkelpaaren zuerst die n-Schenkel (2) und anschließend die entsprechenden p-Schenkel (3) mit dem Kontaktmaterial (4) verschweißt werden und/oder das thermoelektrische Bauelement mehrere Schenkelpaare aufweist, wobei aus einer Auswahl von Schenkelpaaren zuerst die p-Schenkel (3) und anschließend die entsprechenden n-Schenkel (2) mit dem Kontaktmaterial (4) verschweißt werden und/oder das thermoelektrische Bauelement mehrere Schenkelpaare aufweist, und alle n-Schenkel (2) gleichzeitig mit dem Kontaktmaterial (4) verschweißt werden und/oder das thermoelektrische Bauelement mehrere Schenkelpaare aufweist, und alle p-Schenkel (3) gleichzeitig mit dem Kontaktmaterial (4) verschweißt werden.

12. Verfahren nach zumindest einem der Ansprüche 1 bis 11, **dadurch gekennzeichnet, dass** die n- und p-Schenkel (2,3) eines Schenkelpaares auf einer Seite des thermoelektrischen Bauelementes miteinander über das Kontaktmaterial (4) elektrisch verbunden werden, und dass auf der gegenüberliegenden Seite des thermoelektrischen Bauelementes der n-Schenkel (2) des vorgenannten Schenkelpaares mit einem anderen benachbarten p-Schenkel und der p-Schenkel (3) des vorgenannten Schenkelpaares mit einem anderen benachbarten n-Schenkel elektrisch verbunden werden.

13. Verfahren nach Anspruch 12, **dadurch gekennzeichnet, dass** alle n-Schenkel (2) einer Seite gleichzeitig mit dem Kontaktmaterial (4) verschweißt werden und/oder alle p-Schenkel (3) einer Seite gleichzeitig mit dem Kontaktmaterial (4) verschweißt werden, oder alle n- und p-Schenkel (2,3) separat, aber gleichzeitig mit dem Kontaktmaterial (4) verschweißt werden.

14. Thermoelektrisches Bauelement, hergestellt nach einem Verfahren nach zumindest einem der Ansprüche 1 bis 13, mit zumindest einem thermoelektrischen Schenkelpaar, das einen n-Schenkel (2) und einen p-Schenkel (3) aufweist, und das mit zumindest einem elektrisch leitfähigen Kontaktmaterial (4) verschweißt ist, **dadurch gekennzeichnet, dass** das elektrisch leitfähige Kontaktmaterial (4) ein Ende des verschweißten Schenkels (2,3) zumindest teilweise in Radialrichtung (R) desselben umschließt und/oder dass das elektrisch leitfähige Kontaktmaterial (4) in Längsrichtung (L) des verschweißten Schenkels (2,3) mit einer Kontaktfläche desselben verschweißt ist.

15. Thermoelektrisches Bauelement nach Anspruch 14, **dadurch gekennzeichnet, dass** die Schenkel (2,3) unterschiedliche Dimensionen aufweisen.

16. Thermoelektrisches Bauelement nach Anspruch 14 oder 15, **dadurch gekennzeichnet, dass** das Kontaktmaterial (4) aus mehreren Lagen vorzugsweise unterschiedlicher Materialien besteht, die miteinander und/oder dem jeweiligen Schenkel (2,3) verbunden sind und/oder dass das Kontaktmaterial (4) mehrere Lagen vorzugsweise beschichteter Folien aufweist, insbesondere das elektrisch leitfähige Kontaktmaterial (4) mit einem elektrisch leitfähigen Material beschichtet ist.

17. Thermoelektrisches Bauelement nach zumindest einem der Ansprüche 14 bis 20, **dadurch gekennzeichnet, dass** das Kontaktmaterial (4) einen Streifen aus zumindest einem der Elemente Ta, W, Mo, Nb, Ti, Cr, Pd, V, Pt, Rh, Re, Cu, Ag, Ni, Fe, Co, Al, In, Sn, Pb, Te, Sb, Bi, Se, S, Au, Zn, Si oder Ge alleine oder in Kombination mit einem oder mehren anderen Elementen aufweist und/oder mit einem der Elemente Ta, W, Mo, Nb, Ti, Cr, Pd, V, Pt, Rh, Re, Cu, Ag, Ni, Fe, Co, Al, In, Sn, Pb, Te, Sb, Bi, Se, S, Au, Zn, Si oder Ge alleine oder in Kombination mit einem oder mehren anderen Elementen beschichtet ist.

18. Thermoelektrisches Bauelement nach zumindest einem der Ansprüche 14 bis 17, **dadurch gekennzeichnet, dass** die einzelnen Schenkel (2,3) über das Kontaktmaterial (4) elektrisch in Reihe und thermisch parallel verbunden sind und/oder dass das thermoelektrische Bauelement mehrere Schenkelpaare aufweist, deren Schenkel (2,3) über das Kontaktmaterial (4) elektrisch in Reihe und thermisch parallel verbunden sind.

19. Thermoelektrisches Bauelement nach zumindest einem der Ansprüche 14 bis 18, **dadurch gekennzeichnet, dass** die n- und p-Schenkel (2,3) eines Schenkelpaares auf einer Seite des thermoelektrischen Bauelementes miteinander über das Kontaktmaterial (4) elektrisch verbunden sind, und dass auf der gegenüberliegenden Seite des thermoelektrischen Bauelementes der n-Schenkel (2) des vorgenannten Schenkelpaares mit einem anderen benachbarten p-Schenkel und der p-Schenkel (3) des vorgenannten Schenkelpaares mit einem anderen benachbarten n-Schenkel elektrisch verbunden sind und/oder dass die Schenkel (2,3) auf einer Seite oder auf beiden Seiten des thermoelektrischen Bauelementes mit dem Kontaktmaterial (4) verschweißt sind und/oder zwischen benachbarten Schenkeln (2,3) eine mechanische Stabilisierung (13) eingebracht ist, wobei vorzugsweise zumindest einer der Schenkel (2,3) ein Chalkogenid-basiertes Material aufweist.

20. Thermoelektrisches Bauelement nach zumindest einem der Ansprüche 14 bis 19, **dadurch gekennzeichnet, dass** zumindest einer der Schenkel (2,3) an einem oder beiden Enden oder Kontaktflächen zumindest eine zusätzliche Schicht als Diffusionsbarriere (10) und/oder Haftschicht (11) und/oder zur Reduktion des Übergangswiderstandes (9) zum Kontaktmaterial (4) aufweist und/oder dass das Kontaktmaterial (4) zumindest eine zusätzliche Schicht als Diffusionsbarriere (6,8) und/oder Haftschicht und/oder zur Reduktion des Übergangswiderstandes zu dem jeweiligen Schenkel (2,3) aufweist, vorzugsweise das thermoelektrische Bauelement mechanisch flexibel ist.

21. Thermoelektrisches Bauelement nach zumindest einem der Ansprüche 14 bis 20, **dadurch gekennzeichnet, dass** das thermoelektrische Bauelement ein thermoelektrischer Generator oder ein Peltier-Element oder ein Sensorelement ist.

## Claims

1. Method of producing a thermoelectric component with at least one pair of thermoelectric legs comprising an n-leg (2) and a p-leg (3), the two legs (2, 3) being welded to an electrically conductive contact material (4), **characterised in that** the n-leg (2) and the p-leg (3) of the pair of legs are welded to the contact material (4) in separate welding steps.

2. Method as claimed in claim 1, **characterised in that** welding parameters for welding the n-leg (2) and welding parameters for welding the p-leg (3), in particular in a vacuum or under a protective gas atmosphere, are set independently of one another.

3. Method as claimed in claim 1 or 2, **characterised in that** the legs (2, 3) have contact surfaces on at least one of their ends in the longitudinal direction (L) which are moved into contact with the contact material (4), and welding of the n-leg (2) and/or welding of the p-leg (3) takes place on the contact surface and/or to the side of the contact surface of the respective leg (2, 3), and/or welding of the n-leg (2) and/or welding of the p-leg (3) takes place across the entire contact surface of the respective leg (2, 3).

4. Method as claimed in at least one of claims 1 to 3, **characterised in that** the contact material (4) comprises several layers of preferably different materials, which are joined to one another and/or to the respective leg (2, 3) in one or more welding steps.

5. Method as claimed in at least one of claims 1 to 4, **characterised in that** the contact material (4) or a layer disposed thereon reacts physically-chemically with the material of the p-leg (3) and/or a reaction layer disposed thereon and/or reacts physically-chemically with the material of the n-leg (2) and/or a reaction layer disposed thereon, and the reaction layer comprises at least one of the elements Ta, W, Mo, Nb, Ti, Cr, Pd, V, Pt, Rh, Re, Cu, Ag, Ni, Fe, Co, Al, In, Sn, Pb, Te, Sb, Bi, Se, S, Au, Zn, Si or Ge, alone or in combination with another element.

6. Method as claimed in at least one of claims 1 to 5, **characterised in that** before and/or during the respective welding step, the contact material (4) is pressed onto the leg (2, 3) to be welded and/or before and/or during the respective welding step, the contact material (4) is pressed onto the leg (2, 3) to be welded by means of at least one welding electrode.

7. Method as claimed in at least one of claims 1 to 6, **characterised in that** the n-leg (2) and the p-leg (3) of the pair of legs are welded separately to the contact material (4) by resistance welding and/or the n-leg (2) and the p-leg (3) of the pair of legs are welded to the contact material (4) by gap welding.

8. Method as claimed in claim 7, **characterised in that** the contact material (4) is moved into contact with the corresponding leg (2, 3) during gap welding and a gap (BE) of a gap electrode (14) contacting the contact material (4) is set so that it corresponds to a width (B2, B3) of the leg (2, 3) to be welded and/or the contact material (4) is moved into contact with the corresponding leg (2, 3) and a gap (BE) of a gap electrode (14) contacting the contact material (4) is set so that it is wider than a width (B2, B3) of the leg (2, 3) to be welded.

9. Method as claimed in claim 8, **characterised in that** the contact material (4) at least partially surrounds one end of the leg (2, 3) to be welded in a radial direction (R) of the leg (2, 3), and the gap electrode (14) contacts the contact material (4) in the radial direction (R) of the leg (2, 3) to be welded and/or the gap electrode (14) contacts the contact material (4) in the longitudinal direction (L) of the leg (2, 3) to be welded.

10. Method as claimed in at least one of claims 1 to 9, **characterised in that** the n-leg (2) and/or the p-leg (3) of the pair of legs is/are welded to the contact material (4) by protective gas welding, preferably by metal-inert gas welding, tungsteninert gas welding, metal-active gas welding, plasma welding or hydrogen welding or the n-leg (2) and/or the p-leg (3) of the pair of legs is/are welded to the contact material (4) by laser beam welding, and the legs (2, 3) to be welded and/or the contact material (4) are preferably heated prior to welding.

11. Method as claimed in at least one of claims 1 to 10, **characterised in that** the thermoelectric component has several pairs of legs, and from a selection of pairs of legs firstly the n-legs (2) and then the corresponding p-legs (3) are welded to the contact material (4) and/or the thermoelectric component has several pairs of legs, and from a selection of pairs of legs firstly the p-legs (3) and then the corresponding n-legs (2) are welded to the contact material (4) and/or the thermoelectric component has several pairs of legs and all the n-legs (2) are welded simultaneously to the contact material (4) and/or the thermoelectric component has several pairs of legs and all the p-legs (3) are welded simultaneously to the contact material (4).

12. Method as claimed in at least one of claims 1 to 11, **characterised in that** the n-legs and p-legs (2, 3) of a pair of legs at one end of the thermoelectric component are electrically connected to one another via the contact material (4) and the n-leg (2) of the aforesaid pair of legs at the oppositely lying end of the thermoelectric component is electrically connected to another adjacent p-leg and the p-leg (3) of the aforesaid pair of legs is electrically connected to another adjacent n-leg.

13. Method as claimed in claim 12, **characterised in that** all the n-legs (2) of an end are welded to the contact material (4) simultaneously and/or all the p-legs (3) of an end are welded to the contact material (4) simultaneously or all the n-legs and p-legs (2, 3) are welded to the contact material (4) separately but simultaneously.

14. Thermoelectric component produced by a method as claimed in at least one of claims 1 to 13, with at least one pair of thermoelectric legs comprising an n-leg (2) and a p-leg (3), and which is welded to at least one electrically conductive contact material (4), **characterised in that** the electrically conductive contact material (4) surrounds one end of the welded leg (2, 3) at least partially in the radial direction (R) thereof and/or the electrically conductive material (4) is welded in the longitudinal direction (L) of the welded leg (2, 3) to a contact surface thereof.

15. Thermoelectric component as claimed in claim 14, **characterised in that** the legs (2, 3) are of different dimensions.

16. Thermoelectric component as claimed in claim 14 or 15, **characterised in that** the contact material (4) comprises several layers of preferably different materials which are joined to one another and/or to the respective leg (2, 3) and/or the contact material (4) comprises several layers of preferably coated foils, in particular the electrically conductive contact material (4) is coated with an electrically conductive material.

17. Thermoelectric component as claimed in at least one of claims 14 to 20, **characterised in that** the contact material (4) comprises a strip of at least one of the elements Ta, W, Mo, Nb, Ti, Cr, Pd, V, Pt, Rh, Re, Cu, Ag, Ni, Fe, Co, Al, In, Sn, Pb, Te, Sb, Bi, Se, S, Au, Zn, Si or Ge, alone or in combination with one or more other elements and/or is coated with one of the elements Ta, W, Mo, Nb, Ti, Cr, Pd, V, Pt, Rh, Re, Cu, Ag, Ni, Fe, Co, Al, In, Sn, Pb, Te, Sb, Bi, Se, S, Au, Zn, Si or Ge, alone or in combination with one or more other elements

18. Thermoelectric component as claimed in at least one of claims 14 to 17, **characterised in that** the individual legs (2, 3) are connected electrically in series and thermally in parallel via the contact material (4) and/or the thermoelectric component has several pairs of legs, the legs (2, 3) of which are connected electrically in series and thermally in parallel via the contact material (4).

19. Thermoelectric component as claimed in at least one of claims 14 to 18, **characterised in that** the n-legs and p-legs (2, 3) of a pair of legs at one end of the thermoelectric component are electrically connected to one another via the contact material (4), and at the oppositely lying end of the thermoelectric component the n-legs (2) of the aforesaid pair of legs are electrically connected to another adjacent p-leg and the p-leg (3) of the aforesaid pair of legs is electrically connected to another adjacent n-leg and/or the legs (2, 3) at one end or at both ends of the thermoelectric component are welded to the contact material (4) and/or a mechanical stabiliser (13) is inserted between adjacent legs (2, 3), and preferably at least one of the legs (2, 3) has a chalcogenide-based material.

20. Thermoelectric component as claimed in at least one of claims 14 to 19, **characterised in that** at least one of the legs (2, 3) has at one or both ends or contact surfaces at least one additional layer serving as a diffusion barrier (10) and/or adhesive layer (11) and/or to reduce the transition resistance (9) to the contact material (4) and/or the contact material (4) has at least one additional layer serving as a diffusion barrier (6, 8) and/or adhesive layer and/or to reduce the transition resistance to the respective leg (2, 3), the thermoelectric component preferably being mechanically flexible.

21. Thermoelectric component as claimed in at least one of claims 14 to 20, **characterised in that** the thermoelectric component is a thermoelectric generator or a Peltier element or a sensor element.

## Revendications

1. Procédé de fabrication d'un composant thermoélectrique avec au moins une paire de branches thermoélectriques comportant une branche n (2) et une branche p (3) les deux branches (2, 3) étant soudées à un matériau de contact (4), **caractérisé en ce que** la branche n (2) et la branche p (3) de la paire de branches sont soudées au matériau de contact (4) dans des étapes de soudage séparées.

2. Procédé selon la revendication 1, **caractérisé en ce que** les paramètres de soudage pour le soudage de la branche n (2) et les paramètres de soudage pour le soudage de la branche p (3) peuvent être réglés indépendamment les uns des autres, s'effectuant en particulier dans un vide ou sous une atmosphère de protection.

3. Procédé selon la revendication 1 ou 2, **caractérisé en ce que** les branches (2, 3) comportent au moins à l'une de leurs extrémités dans le sens de la longueur (L) des surfaces de contact qui peuvent être mises en contact avec le matériau de contact (4), et **en ce que** le soudage de la branche n (2) et/ou le soudage de la branche p (3) s'effectuent sur la surface de contact et/ou sur le côté de la surface de contact de la branche (2, 3) respective, et/ou **en ce que** le soudage de la branche n (2) et/ou le soudage de la branche p (3) s'effectuent sur l'ensemble de la surface de contact de la branche (2, 3) respective.

4. Procédé selon l'une au moins des revendications 1 à 3, **caractérisé en ce que** le matériau de contact (4) consiste en plusieurs couches, de préférence de matériaux différents, qui sont assemblées ensemble et/ou à la branche (2, 3) respective en une ou plusieurs étapes de soudage.

5. Procédé selon l'une au moins des revendications 1 à 4, **caractérisé en ce que** le matériau de contact (4) ou une couche se trouvant dessus réagit physico-chimiquement avec le matériau de la branche p (3) et/ou une couche de réaction se trouvant dessus et/ou physico-chimiquement avec le matériau de la branche n (2) et/ou une couche de réaction se trouvant dessus, et **en ce que** la couche de réaction consiste en en au moins un des éléments Ta, W, Mo, Nb, Ti, Cr, Pd, V, Pt, Rh, Re, Cu, Ag, Ni, Fe, Co, Al, In, Sn, Pb, Te, Sb, Bi, Se, S, Au, Zn, Si ou Ge, seuls ou en combinaison avec un autre élément.

6. Procédé selon l'une au moins des revendications 1 à 5, **caractérisé en ce qu'**avant et/ou pendant l'étape de soudage respective, le matériau de contact (4) est pressé sur la branche (2, 3) à souder et/ou **en ce qu'**avant et/ou pendant l'étape de soudage respective, le matériau de contact (4) est pressé par au moins une électrode de soudage sur la branche (2, 3) à souder.

7. Procédé selon l'une au moins des revendications 1 à 6, **caractérisé en ce que** la branche n (2) et la branche p (3) de la paire de branches sont soudées séparément au matériau de contact (4) par soudage par résistance et/ou **en ce que** la branche n (2) et la branche p (3) de la paire de branches sont soudées au matériau de contact (4) par soudage entre fente.

8. Procédé selon la revendication 7, **caractérisé en ce que** lors du soudage entre fente, le matériau de contact (4) est amené en contact avec la branche (2, 3) correspondante et **en ce qu'**une fente (BE) d'une électrode fendue (14) mise en contact avec le matériau de contact (4) est réglée en fonction d'une largeur (B2, B3) de la branche (2, 3) à souder, et/ou **en ce que** le matériau de contact (4) est mis en contact avec la branche correspondante (2, 3) et qu'une fente (BE) d'une électrode fendue (14) en contact avec le matériau de contact (4) est réglée plus large qu'une largeur (B2, B3) de la branche (2, 3) à souder.

9. Procédé selon la revendication 8, **caractérisé en ce que** le matériau de contact (4) enserre au moins en partie une extrémité de la branche (2, 3) à souder dans une direction radiale (R) de la branche (2, 3) à souder, et **en ce que** l'électrode fendue (14) arrive en contact avec le matériau de contact (4) dans la direction radiale (R) de la branche (2, 3) à souder et/ou **en ce que** l'électrode fendue (14) entre en contact avec le matériau de contact (4) dans la direction longitudinale (L) de la branche (2, 3) à souder.

10. Procédé selon l'une au moins des revendications 1 à 9, **caractérisé en ce que** la branche n (2) et/ou la branche p (3) de la paire de branches sont soudées au matériau de contact (4) par soudage sous gaz de protection, de préférence par soudage métal-gaz inerte, par soudage tungstène-gaz inerte, par soudage métal-gaz actif, par soudage à plasma ou par soudage à hydrogène ou **en ce que** la branche n (2) et/ou la branche p (3) de la paire de branches sont soudées au matériau de contact (4) par soudage au faisceau laser, les branches (2, 3) à souder et/ou le matériau de contact (4) étant préchauffés avant le soudage.

11. Procédé selon l'une au moins des revendications 1 à 10, **caractérisé en ce que** le composant thermoélectrique comprend plusieurs paires de branches, sachant que parmi une sélection de paires de branches, d'abord les branches n (2), et ensuite les branches p (3) correspondantes sont soudées au matériau de contact (4) et/ou **en ce que** le composant thermoélectrique comporte plusieurs paires de branches sachant que parmi une sélection de paires de branches, d'abord les branches p (3), et ensuite les branches n (2) correspondantes sont soudées au matériau de contact (4) et/ou **en ce que** le composant thermoélectrique comporte plusieurs paires de branches et que toutes les branches n (2) sont soudées en même temps au matériau de contact (4) et/ou **en ce que** le composant thermoélectrique comporte plusieurs paires de branches et que toutes les branches p (3) sont soudées en même temps au matériau de contact (4).

12. Procédé selon l'une au moins des revendications 1 à 11, **caractérisé en ce que** les branches n et p (2, 3) d'une paire de branches sont reliées ensemble électriquement d'un côté du composant thermoélectrique par l'intermédiaire du matériau de contact (4), et **en ce que** du côté opposé du composant thermoélectrique la branche n (2) de la paire de branches susmentionnée est reliée électriquement à une autre branche p voisine et que la branche p (3) de la paire de branches susmentionnée est reliée électriquement à une autre branche n voisine.

13. Procédé selon la revendication 12, **caractérisé en ce que** toutes les branches n (2) d'un côté sont soudées en même temps au matériau de contact (4) et/ou en ce que toutes les branches p (3) d'un côté sont soudées en même temps au matériau de contact (4), ou **en ce que** toutes les branches n et p (2, 3) sont soudées séparément mais en même temps au matériau de contact (4).

14. Composant thermoélectrique fabriqué selon un procédé selon l'une au moins des revendications 1 à 13, avec au moins une paire de branches thermoélectriques qui comporte une branche n (2) et une branche p (3), et qui est soudée à au moins un matériau de contact (4) électriquement conducteur, **caractérisé en ce que** le matériau de contact (4) électriquement conducteur enserre au moins partiellement une extrémité de la branche (2, 3) soudée dans la direction radiale (R) de celle-ci, et/ou **en ce que** le matériau de contact (4) électriquement conducteur est soudé dans la direction longitudinale (L) de la branche (2, 3) soudée à une surface de contact de celle-ci.

15. Composant thermoélectrique selon la revendication 14, **caractérisé en ce que** les branches (2, 3) ont des dimensions différentes.

16. Composant thermoélectrique selon la revendication 14 ou 15, **caractérisé en ce que** le matériau de contact (4) consiste en plusieurs couches, de préférence de matériaux différents, qui sont reliées ensemble et/ou à la branche (2, 3) respective, et/ou **en ce que** le matériau de contact (4) comporte plusieurs couches de films, de préférence revêtus, en particulier que le matériau de contact (4) électriquement conducteur est revêtu d'un matériau électriquement conducteur.

17. Composant thermoélectrique selon l'une au moins des revendications 14 à 20, **caractérisé en ce que** le matériau de contact (4) comporte une bande en au moins un des éléments Ta, W, Mo, Nb, Ti, Cr, Pd, V, Pt, Rh, Re, Cu, Ag, Ni, Fe, Co, Al, In, Sn, Pb, Te, Sb, Bi, Se, S, Au, Zn, Si ou Ge, seuls ou en combinaison avec un ou plusieurs autres éléments et/ou est revêtu d'un des éléments Ta, W, Mo, Nb, Ti, Cr, Pd, V, Pt, Rh, Re, Cu, Ag, Ni, Fe, Co, Al, In, Sn, Pb, Te, Sb, Bi, Se, S, Au, Zn, Si ou Ge, seuls ou en combinaison avec un ou plusieurs autres éléments.

18. Composant thermoélectrique selon l'une au moins des revendications 14 à 17, **caractérisé en ce que** les différentes branches (2, 3) sont reliées par le matériau de contact (4) électriquement en série et thermiquement en parallèle et/ou **en ce que** le composant thermoélectrique comporte plusieurs paires de branches, dont les branches (2, 3) sont reliées par le matériau de contact (4) électriquement en série et thermiquement en parallèle.

19. Composant thermoélectrique selon l'une au moins des revendications 14 à 18, **caractérisé en ce que** les branches n et p (2, 3) d'une paire de branches sont reliées ensemble électriquement d'un côté du composant thermoélectrique par l'intermédiaire du matériau de contact (4), et **en ce que** du côté opposé du composant thermoélectrique, la branche n (2) de la paire de branches susmentionnée est reliée électriquement à une autre branche p voisine et que la branche p (3) de la paire de branches susmentionnée est reliée électriquement à une autre branche n voisine, et/ou **en ce que** les branches (2, 3) sont soudées au matériau de contact (4) d'un côté ou des deux côtés du composant thermoélectrique et/ou **en ce qu'**un renfort mécanique (13) est apposé entre deux branches (2, 3) voisines, l'une au moins des branches (2, 3) comportant un matériau à base de chalcogénure.

20. Composant thermoélectrique selon l'une au moins des revendications 14 à 19, **caractérisé en ce qu'**au moins une des branches (2, 3) comporte à une ou aux deux extrémités ou surfaces de contact au moins une couche supplémentaire comme barrière de diffusion (10) et/ou comme couche d'adhérence (11) et/ou pour la réduction de la résistance de passage (9) au matériau de contact (4) et/ou **en ce que** le matériau de contact (4) comporte au moins une couche supplémentaire comme barrière de diffusion (6, 8) et/ou comme couche d'adhérence et/ou pour la réduction de la résistance de passage à la branche (2, 3) respective, le composant thermoélectrique étant de préférence mécaniquement flexible.

21. Composant thermoélectrique selon l'une au moins des revendications 14 à 20, **caractérisé en ce que** le composant thermoélectrique est un générateur thermoélectrique ou un élément de Peltier ou un élément capteur.
